# EUROPEAN PATENT APPLICATION

(11) **EP 1 316 625 A1**
(43) Date of publication of application: **04.06.2003**
(21) Application number: 02079778.3
(22) Date of filing: 18.11.2002
(51) Int. Cl.: C23C 14/12, C23C 14/26, C23C 14/24

(54) **Thermal physical vapor deposition source**

(30) Priority: 28.11.2001 US 996415
(71) Applicant: EASTMAN KODAK COMPANY, Rochester, New York 14650 (US)
(72) Inventor: Van Slyke, Steven A., Rochester, New York 14650-2201 (US); Spahn, Robert George, Rochester, New York 14650-2201 (US)
(74) Representative: Weber, Etienne Nicolas

(57) **Abstract**

A thermal physical vapor deposition source for vaporizing solid organic materials in forming an OLED on a structure includes a bias heater (20), an electrically insulative container (30) disposed in the bias heater, and a vaporization heater (40) disposed on the container. Relative motion is provided between the source and the structure to provide a substantially uniform organic layer on the structure.

## Description

The present invention relates generally to a thermal physical vapor deposition source for making organic layers on a structure which will form part of an organic light-emitting device (OLED).

An organic light-emitting device, also referred to as an organic electroluminescent device, can be constructed by sandwiching two or more organic layers between first and second electrodes.

In a passive matrix organic light-emitting device (OLED) of conventional construction, a plurality of laterally spaced light-transmissive anodes, for example indium-tin-oxide (ITO) anodes, are formed as first electrodes on a light-transmissive substrate such as, for example, a glass substrate. Two or more organic layers are then formed successively by vapor deposition of respective organic materials from respective sources, within a chamber held at reduced pressure, typically less than 10⁻³ Torr. A plurality of laterally spaced cathodes are deposited as second electrodes over an uppermost one of the organic layers. The cathodes are oriented at an angle, typically at a right angle, with respect to the anodes.

Such conventional passive matrix organic light-emitting devices are operated by applying an electrical potential (also referred to as a drive voltage) between appropriate columns (anodes) and, sequentially, each row (cathode). When a cathode is biased negatively with respect to an anode, light is emitted from a pixel defined by an overlap area of the cathode and the anode, and emitted light reaches an observer through the anode and the substrate.

In an active matrix organic light-emitting device (OLED), an array of anodes are provided as first electrodes by thin-film transistors (TFTs) which are connected to a respective light-transmissive portion. Two or more organic layers are formed successively by vapor deposition in a manner substantially equivalent to the construction of the aforementioned passive matrix device. A common cathode is deposited as a second electrode over an uppermost one of the organic layers. The construction and function of an active matrix organic light-emitting device is described in US-A-5,550,066, the disclosure of which is herein incorporated by reference.

Organic materials, thicknesses of vapor-deposited organic layers, and layer configurations, useful in constructing an organic light-emitting device, are described, for example, in US-A-4,356,429, US-A-4,539,507, US-A-4,720,432, and US-A-4,769,292, the disclosures of which are herein incorporated by reference.

A source for thermal physical vapor deposition of organic layers onto a structure for making an organic light-emitting device has been disclosed by Robert G. Spahn in commonly assigned US-A-6,237,529, issued May 29, 2001. The source disclosed by Spahn includes a housing which defines an enclosure for receiving solid organic material which can be vaporized. The housing is further defined by a top plate which defines a vapor efflux slit aperture for permitting vaporized organic materials to pass through the slit onto a surface of a structure. The housing defining the enclosure is connected to the top plate. The source disclosed by Spahn further includes a conductive baffle member attached to the top plate. This baffle member provides line-of-sight covering of the slit in the top plate so that vaporized organic material can pass around the baffle member and through the slit onto the substrate or structure while particles of organic materials are prevented from passing through the slit by the baffle member when an electrical potential is applied to the housing to cause heat to be applied to the solid organic material in the enclosure causing the solid organic material to vaporize.

In using the thermal physical vapor deposition source disclosed by Spahn to form an organic layer of a selected organic material on a plurality of substrates or structures, it has been found that organic material remaining in the enclosure, or residue of organic material remaining in the enclosure, is difficult to remove, particularly from inside comers of the enclosure defined by the housing. Repeated mechanical scrubbing is required to effectively remove traces of such previously used organic material prior to loading the enclosure with fresh organic material, especially if the fresh load of organic material is different from the previously used organic material. For example, if the previously received solid organic material in the enclosure was an organic hole-transporting material, any residue of such organic hole-transporting material has to be removed completely prior to loading, for example, an organic light-emitting material into the housing defining the enclosure so as to avoid contamination of the light-emitting material by even a trace quantity of the previously used hole-transporting material.

Effective and known methods of cleaning organic residue from surfaces such as, for example, immersion of an enclosure of a container into an acid bath ("acid cleaning"), or subjecting an enclosure or an interior surface of a container to a strong oxidizing agent, cannot be employed for cleaning the source disclosed by Spahn, since the metal used to form the enclosure can be adversely affected by such cleaning procedures.

It is an object of the present invention to provide a thermal physical vapor deposition source for forming organic layers on a structure which will form part of an organic light-emitting device (OLED).

It is another object of the invention to provide a thermal physical vapor deposition source for forming organic layers on a structure which will form part of an OLED, the source including a bias heater, an electrically insulative container disposed in the bias heater for receiving solid organic material which can be vaporized, and a vaporization heater disposed on the container.

It is a further object of the present invention to provide a thermal physical vapor deposition source for forming organic layers on a structure which will form part of an OLED, and including means for moving the source with respect to a surface of the structure to provide substantially uniform layers on the structure.

These and other objects are achieved by a thermal physical vapor deposition source for vaporizing solid organic materials and applying a vaporized organic material as a layer onto a surface of a structure in a chamber at reduced pressure in forming an organic light-emitting device (OLED), comprising:
a) a bias heater defined by side walls and a bottom wall, the side walls having a height dimension H_{B};
b) an electrically insulative container disposed in the bias heater, the container receiving solid organic material which can be vaporized, the container defined by side walls and a bottom wall, and the container side walls having a height dimension H_{C} which is greater than the height dimension H_{B} of the bias heater side walls;
c) a vaporization heater disposed on upper side wall surfaces of the container, the vaporization heater defining a vapor efflux slit aperture extending into the container for permitting vaporized organic material to pass through the slit aperture and onto the surface of the structure;
d) means for applying an electrical potential to the bias heater to cause bias heat to be applied to the solid organic material in the container, the bias heat providing a bias temperature which is insufficient to cause the solid organic material to vaporize;
e) means for applying an electrical potential to the vaporization heater to cause vaporization heat to be applied to uppermost portions of the solid organic material in the container causing such uppermost portions to vaporize so that vaporized organic material is projected onto the structure through the efflux slit aperture to provide an organic layer on the structure; and
f) means for providing relative motion between the vapor deposition source and the structure to provide a substantially uniform organic layer on the structure.

### ADVANTAGES

A feature of the present invention is that an electrically insulative container is disposed in a bias heater which provides a bias heat to the solid organic material received in the container so that gases or volatile compounds entrained in the organic material can be released therefrom at a bias heater temperature which is insufficient to cause vaporization of the organic material.

Another feature of the present invention is that solid organic material received in the container is heated by the bias heater to a controlled bias temperature so that a vaporization heater can be operated at a reduced and controlled vaporization heater temperature sufficient to vaporize the solid organic material in the container, thereby minimizing potential decomposition of portions of the organic material in the container.

Another feature of the present invention is that the electrically insulative container is disposed in a bias heater which provides a bias heat to the solid organic material received in the container so that gases entrained in the organic material can be released therefrom at a bias temperature which is insufficient to cause vaporization of the organic material.

Another feature of the present invention is that relative motion can be effected between the vapor deposition source and a structure so that a substantially uniform organic layer can be provided over a surface of the structure.

A feature of the present invention is that an electrically insulative container for receiving solid organic material to be vaporized is readily cleanable of residue of organic material by known and effective cleaning processes.

FIG. 1 is a schematic perspective view of a passive matrix organic light-emitting device having partially peeled-back elements to reveal various layers;

FIG. 2 is a schematic perspective view of an OLED apparatus suitable for making a relatively large number of organic light-emitting devices (OLEDs) and having a plurality of stations extending from hubs;

FIG. 3 is a schematic section view of a carrier containing a relatively large number of substrates or structures, and positioned in a load station of the apparatus of FIG. 2 as indicated by section lines 3-3 in FIG. 2;

FIG. 4 is an exploded schematic perspective view of a thermal physical vapor deposition source in accordance with the present invention;

FIG. 5 is a schematic sectional view of a thermal physical vapor deposition source in accordance with one aspect of the present invention in which a powder of organic material is received in a container, the container disposed in a bias heater, and a vaporization heater with attached baffle member disposed over the container;

FIG. 6 is a schematic sectional view of a thermal physical vapor deposition source in accordance with another aspect of the present invention in which solid pellets of organic material are received in a container, the container disposed in a bias heater, and a vaporization heater disposed over the container;

FIG. 7 is a schematic sectional view of a vapor deposition station dedicated to forming vapor-deposited organic electron-transporting layers (ETL) on structures in the apparatus of FIG. 2 as indicated by section lines 7-7 in FIG. 2, and showing end views of a vapor deposition source being moved by a lead screw to provide a uniformly vapor-deposited organic electron-transporting layer over the structure, in accordance with an aspect of the present invention; and

FIG. 8 is a schematic top view of a portion of the ETL vapor deposition station of FIG. 2, and indicating forward and reverse motion of the vapor deposition source from and to a parked position in which vapor deposition and bias heater temperature are monitored by respective sensing devices, in accordance with another aspect of the present invention.

The drawings are necessarily of a schematic nature since layer thickness dimensions of OLEDs are frequently in the sub-micrometer ranges, while features representing lateral device dimensions can be in a range of 50-500 millimeter. Accordingly, the drawings are scaled for ease of visualization rather than for dimensional accuracy.

The term "substrate" denotes a light-transmissive support having a plurality of laterally spaced first electrodes (anodes) preformed thereon, such substrate being a precursor of a passive matrix OLED. The term "structure" is used to describe the substrate once it has received a portion of a vapor deposited organic layer, and to denote an active matrix array as a distinction over a passive matrix precursor.

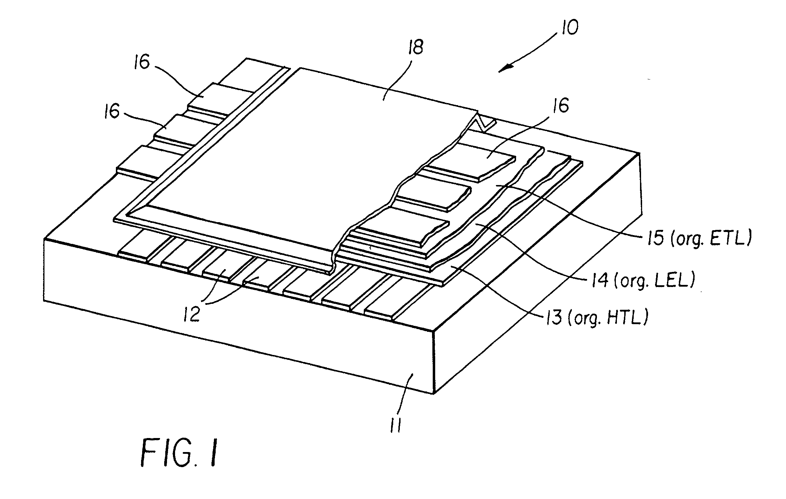

Turning to FIG. 1, a schematic perspective view of a passive matrix organic light-emitting device (OLED) 10 is shown having partially peeled-back elements to reveal various layers.

A light-transmissive substrate 11 has formed thereon a plurality of laterally spaced first electrodes 12 (also referred to as anodes). An organic hole-transporting layer (HTL) 13, an organic light-emitting layer (LEL) 14, and an organic electron-transporting layer (ETL) 15 are formed in sequence by a physical vapor deposition, as will be described in more detail hereinafter. A plurality of laterally spaced second electrodes 16 (also referred to as cathodes) are formed over the organic electron-transporting layer 15, and in a direction substantially perpendicular to the first electrodes 12. An encapsulation or cover 18 seals environmentally sensitive portions of the structure, thereby providing a completed OLED 10.

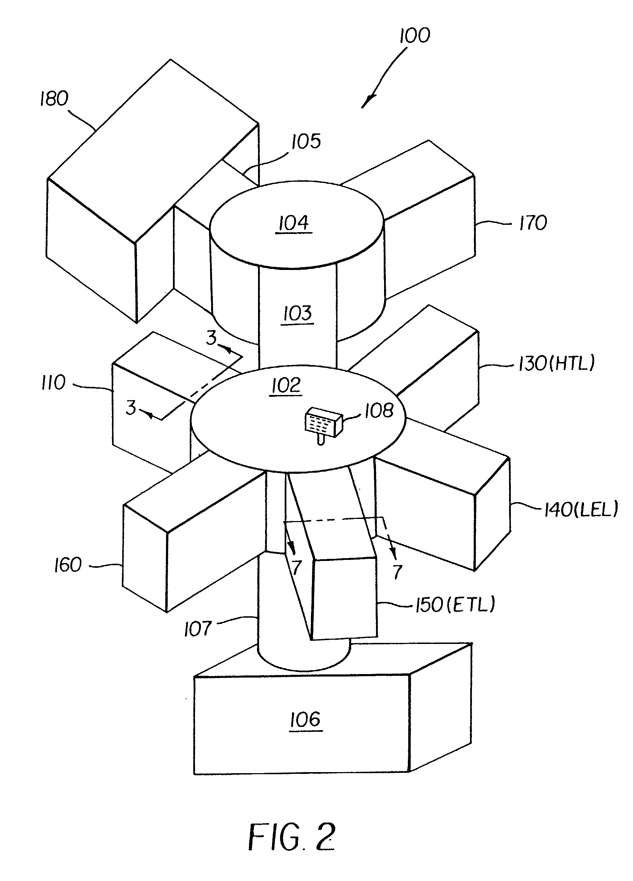

Turning to FIG. 2, a schematic perspective view of an OLED apparatus 100 is shown which is suitable for making a relatively large number of organic light-emitting devices using automated or robotic means (not shown) for transporting or transferring substrates or structures among a plurality of stations extending from a buffer hub 102 and from a transfer hub 104. A vacuum pump 106 via a pumping port 107 provides reduced pressure within the hubs 102, 104, and within each of the stations extending from these hubs. A pressure gauge 108 indicates the reduced pressure within the system 100. The pressure is typically lower than 10⁻³ Torr.

The stations include a load station 110 for providing a load of substrates or structures, a vapor deposition station 130 dedicated to forming organic hole-transporting layers (HTL), a vapor deposition station 140 dedicated to forming organic light-emitting layers (LEL), a vapor deposition station 150 dedicated to forming organic electron-transporting layers (ETL), a vapor deposition station 160 dedicated to forming the plurality of second electrodes (cathodes), an unload station 103 for transferring structures from the buffer hub 102 to the transfer hub 104 which, in turn, provides a storage station 170, and an encapsulation station 180 connected to the hub 104 via a connector port 105. Each of these stations has an open port extending into the hubs 102 and 104, respectively, and each station has a vacuum-sealed access port (not shown) to provide access to a station for cleaning, replenishing materials, and for replacement or repair of parts. Each station includes a housing which defines a chamber.

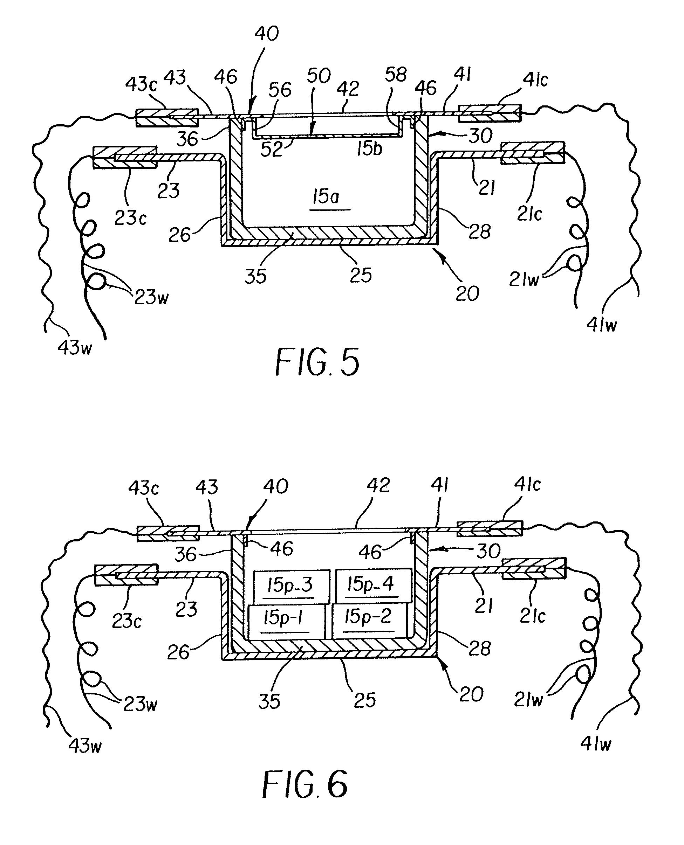

In the detailed description of FIGS. 5-8, organic electron-transporting material is depicted as an illustrative example of an organic material for forming an organic electron-transporting layer 15 (see FIG. 1) in the station 150 (ETL) of FIG. 2. It will be appreciated that a thermal physical vapor deposition source can be effectively used in accordance with aspects of the present invention to form an organic light-emitting layer 14 (see FIG. 1) in the station 140 (LEL) of FIG. 2, or to form an organic hole-transporting layer 13 (see FIG. 1) in the station 130 (HTL) of FIG. 2.

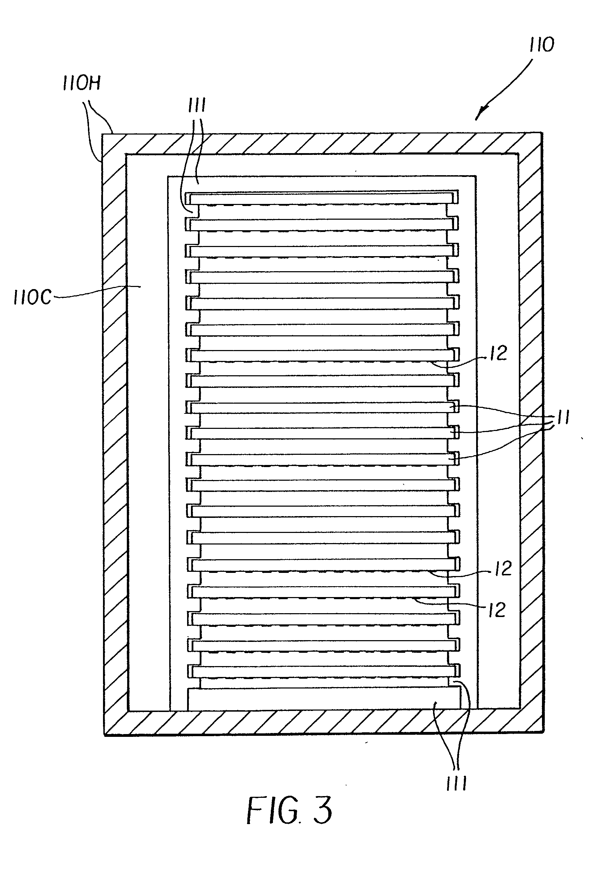

FIG. 3 is a schematic section view of the load station 110, taken along section lines 3-3 of FIG. 2. The load station 110 has a housing 110H which defines a chamber 110C. Within the chamber is positioned a carrier 111 designed to carry a plurality of substrates 11 having preformed first electrodes 12 (see FIG. 1). An alternative carrier 111 can be provided for supporting a plurality of active matrix structures. Carriers 111 can also be provided in the unload station 103 and in the storage station 170.

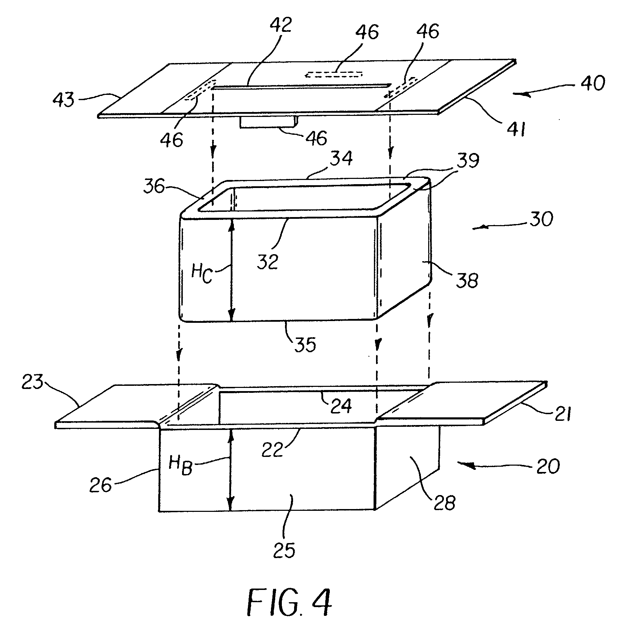

Turning to FIG. 4, an exploded schematic perspective view of a thermal physical vapor deposition source is shown, constructed in accordance with the present invention. The source includes a bias heater 20 having side walls 22, 24, end walls 26, 28, and a bottom wall 25. Electrical connecting flanges 21 and 23 extend from the end walls 28 and 26, respectively. The bias heater 20 is constructed of a metal having low to moderate electrical conductivity, superior mechanical strength and stability in repeated use cycles at elevated "bias" temperature, and an ability to be readily shaped into a desired shape. Tantalum is a preferred metal which meets these requirements. The bias heater has a height dimension H_{B}.

The source further includes an electrically insulative container 30 having side walls 32, 34, end walls 36, 38, and a bottom wall 35. Side walls 32, 34 and end walls 36, 38 share a common upper surface 39. The electrically insulative container 30 is preferably constructed of quartz or of a ceramic material. Such materials are substantially resistant to acids or strong oxidizing agents which are commonly used to remove organic materials or organic residue from the container which received such organic material, as described in more detail with reference to FIGS. 5 and 6. The container has a height dimension H_{C} which is greater than the height dimension H_{B} of the bias heater 20. Arrows along dotted lines are intended to indicate that the container 30 is lowered into the bias heater 20 to be disposed therein (see FIGS. 5 and 6).

An upper element of the source is a vaporization heater 40 which is also preferably constructed of tantalum metal. The vaporization heater 40 is substantially a planar structure which includes electrical connecting flanges 41, 43, a vapor efflux slit aperture 42, and centering or retaining flanges 46 which provide for centering and retaining of the vaporization heater 40 on the common upper surface 39 of the container 30 upon lowering the vaporization heater 40 onto the container 30 as indicated by the arrows along the dotted lines. The vapor efflux slit aperture will then be centered within inside dimensions (not identified in FIG. 4) of the container 30.

Viewing FIG. 5 and FIG. 6 together, there are shown schematic sectional views of thermal physical vapor deposition sources constructed in accordance with aspects of the present invention with distinguishing features being related to the physical properties of the organic material received in, or loaded into, the container 30. In FIGS. 5 and 6, the numeral designations of FIG. 4 have been retained for the purpose of clarity of presentation, and additional like numeral designations refer to like parts or like functions among the thermal physical vapor deposition sources shown in FIGS. 5 and 6. For example, connecting clamps 21c, 23c, and 41c, 43c are identical elements performing identical functions of connecting corresponding electrical connecting flanges 21, 23 and 41, 43 with corresponding electrical leads 21w, 23w and 41w, 43w, respectively.

In FIG. 5, the electrically insulative container 30 has received an organic electron-transporting material 15a in the form of a powder, flakes, or particulates, filled to an initial level 15b. In this case, the vaporization heater 40 includes a baffle member 50 having a baffle surface 52 which substantially covers the vapor efflux slit aperture 42, so that during vapor deposition onto a structure, vapors of organic material can pass about the baffle member 50 and be directed via the slit aperture 42 towards the structure which is to receive an organic layer, while powder particles or flake particles are blocked by the baffle member from reaching the slit aperture 42. The baffle member 50 is connected to the vaporization heater 40 by baffle terminations 56 and 58 which also provide mechanical support to the baffle member 50. Thus, when the container 30 receives a charge of organic material in the form of a powder, flakes, or particulates, the vaporization heater 40 and attached baffle member 50 are related in construction to the top plate disclosed by Spahn in US-A-6,237,529 cited above.

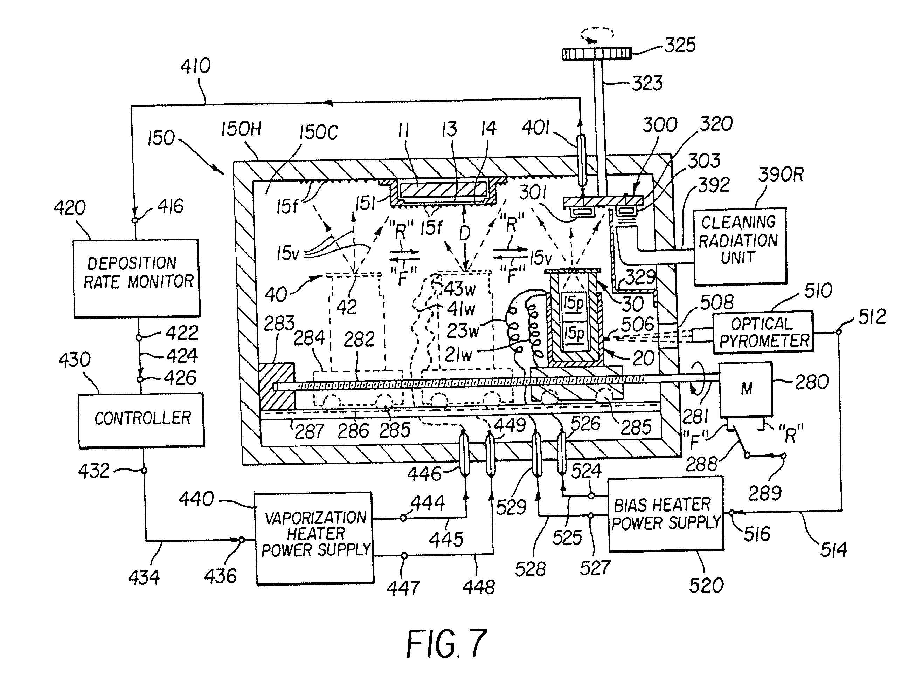

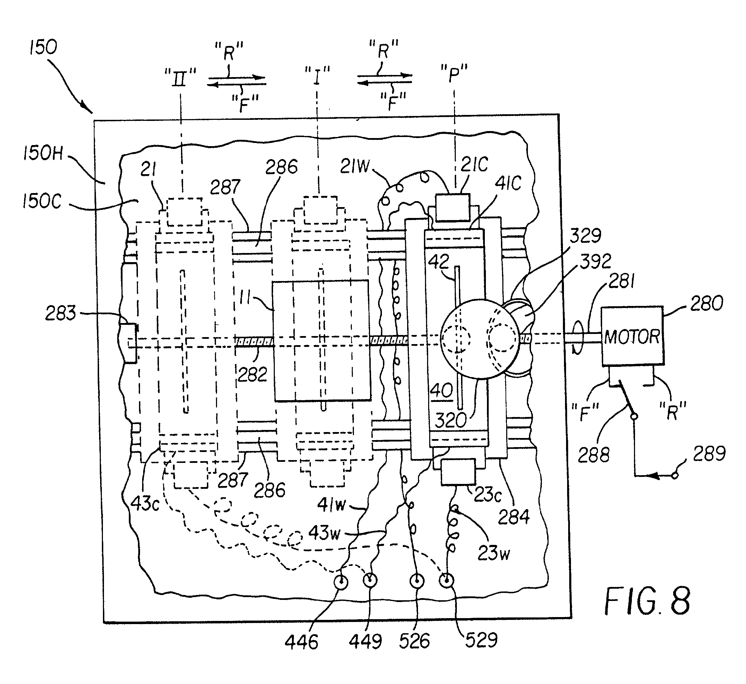

For visual distinction, particularly with reference to FIGS. 7 and 8, the electrical leads 41w and 43w associated with the vaporization heater 40 are shown in a wavy outline, while electrical leads 21w and 23w associated with the bias heater 20 are depicted in coiled outline.

In FIG. 6, the container 30 received organic electron-transporting material in the form of solid agglomerated pellets 15p-1, 15p-2, 15p-3, and 15p-4.

Since the solid pellets are relatively highly agglomerated or compacted, they are substantially free of loose particles. Accordingly, the vaporization heater 40 can be constructed without the baffle member 50 described with reference to FIG. 5.

Turning to FIG. 7, a schematic sectional view of the vapor deposition station 150 of FIG. 2 is shown which is dedicated to forming vapor-deposited organic electron-transporting layers (ETL) on structures by using a vapor deposition source of the present invention. The station 150 has a housing 150H which defines a chamber 150C. A structure 11, having a vapor-deposited organic hole-transporting layer 13 and a vapor-deposited organic light-emitting layer 14, is supported in a holder and/or in a mask frame 151 within the chamber 150C which is at reduced pressure (see FIG. 2), typically at a pressure lower than 10⁻³ Torr.

The thermal physical vapor deposition source, which includes the bias heater 20, the container 30, and the vaporization heater 40, is shown in solid sectional view in a parked position "P" (see FIG. 8), and in dashed outline at an intermediate position "I" and at an end position "II" of the source during a forward motion "F" or a reverse motion "R" of the source, as indicated by respective arrows of these motions.

The source is disposed on a thermally and electrically insulative carriage 284 having carriage wheels 285 which are guided in a wheel groove 286 or a wheel recess formed in a carriage rail 287. A lead screw 282 extends through a threaded bore (not shown) of the carriage 284. The lead screw 282 is supported on one end by a lead screw shaft termination bracket 283, and extends as a lead screw shaft 281 through the housing 150 to a motor 280. This portion of the lead screw shaft 281 passes through the housing via a vacuum seal (not shown). Such seals are commonly used for rotating elements which extend into or out of a vacuum system.

The motor 280 provides for forward motion "F" of the carriage 284 or for reverse motion "R" via a switch 288 which provides a control signal to the motor from an input terminal 289. The switch 288 can have an intermediate or "neutral" position (not shown) in which the carriage remains in the "parked" position shown in solid outline of the carriage and the source.

In the "parked" position of the source, a first control signal is generated by a temperature-measuring device which measures the temperature of the bias heater 20. This device is depicted in FIG. 7 as an optical pyrometer 510 which collects a portion of a bias heater temperature radiation 506 via window 508 in the housing 150H, and which provides a corresponding bias heater control signal at an output terminal 512. This control signal, which can alternatively be generated by a thermocouple attached to the bias heater 20, is provided at an input terminal 516 of a bias heater power supply 520 via a lead 514. This bias heater power supply 520 has output terminals 524 and 527 which are connected via respective leads 525 and 528 to respective power feed throughs 526 and 529 sealingly disposed in the housing 150H. The coiled electrical leads 21w and 23w are connected to the power feed throughs 526 and 529, respectively, and are shown schematically to terminate at the bias heater 20. The electrical connecting flanges 21 and 23 and connecting clamps 21c and 23c of FIGS. 5 and 6 have been omitted from the drawing of FIG. 7 to preserve visual clarity.

The electrical potential provided by the bias heater power supply 520 to the bias heater 20 under control by the bias heater temperature control signal is selected so that the bias heater is maintained at a temperature which is insufficient to cause organic material (depicted in the form of two solid pellets 15p received in the container 30 of FIG. 7) to vaporize in the container. However, the bias heater temperature is sufficient to release entrained gases and/or entrained moisture or volatile compounds from the organic material received in the container.

A second control signal is generated in the "parked" position "P" of the source when the vaporization heater 40 is actuated to vaporize uppermost portions of the organic material (uppermost portions of the upper pellet in FIG. 7). The vaporized organic material leaves the source through the vapor efflux slit aperture 42 which extends into the container 30 from the vaporization heater 40. A deposition zone 15v is defined by the vapor of organic electron-transporting material in the chamber 150C.

Located in the deposition zone 15v in the "parked" position "P" (see FIG. 8) of the source is shown a mass-sensor assembly 300 which supports at least two crystal mass-sensors 301 and 303. The crystal mass-sensor 301 is in a sensing position and receives organic material. Sensor 301 is connected via a sensor signal feed through 401 and a sensor signal lead 410 to an input terminal 416 of a deposition rate monitor 420. The monitor 420 provides for selection of a desired vapor deposition rate, that is a desired rate of mass build-up on the sensor 301, and the monitor includes an oscillator circuit (not shown) which includes the crystal mass-sensor 301, as is well known in the art of monitoring vapor deposition processes. The deposition rate monitor 420 provides an output signal at an output terminal 422 thereof, and this monitor output signal becomes an input signal to a controller or amplifier 430 via a lead 424 at an input terminal 426. An output signal at output terminal 432 of the controller or amplifier 430 is connected via a lead 434 to an input terminal 436 of a vaporization heater power supply 440. The vaporization heater power supply 440 has two output terminals 444 and 447 which are connected via respective leads 445 and 448 to corresponding power feed throughs 446 and 449 disposed in the housing 150H. The vaporization heater 40, in turn, is connected to the power feed throughs 446, 449 with electrical leads 41w and 43w, respectively, as depicted schematically in dotted wavy outline in the intermediate position of the source.

Thus, in the "parked" position "P" of the source (see FIG. 8), a bias heater temperature control signal controls the bias heater power supply 520 to provide a controlled bias heater temperature of the bias heater 20, and a vapor deposition rate control signal controls the vaporization heater power supply 440 to provide a controlled temperature of the vaporization heater 40 with a correspondingly controlled vaporization of the organic material received in the container 30. The controlled bias heater temperature permits selection of a controlled vaporization heater temperature which can be reduced compared to a vaporization heater temperature which would be required in the absence of heating the bias heater. This "temperature-additive" effect of a controlled bias heater temperature has been shown to be advantageous when organic materials are received in the container which are subject to partial decomposition at too high a vaporization heater temperature.

Upon establishing the above-described controlled conditions, the carriage 284 is moved or translated in a forward direction "F" from the "parked" position "P" via an intermediate position "I" to an end position "II", from which the source is returned in a reverse direction "R" via an intermediate position "I" to the parked position "P", as detailed in FIG. 8.

The vapor efflux slit aperture 42 and the vaporization heater 40 are spaced from the structure by a distance D which is selected to provide a desirable vapor flux in the deposition zone 15v so that a partial layer 15f of organic electron-transporting material is being formed on the structure 11 during the forward motion "F" of the source, and a completed organic electron-transporting layer 15 (ETL) is provided during the reverse motion "R" past the structure 11 to return to the "parked" position "P" of the source, in which the previously described control signals are again provided.

While the thermal physical vapor deposition source is in the parked position, the structure 11 is removed from the chamber 150 via robotic means (not shown) and is advanced to another station, for example station 160, of the OLED apparatus 100 of FIG. 2, via the buffer hub 102. A new structure is advanced into the holder or mask frame 151 of the chamber 150C for vapor deposition of an organic electron-transporting layer 15 in the manner described above.

The mass-sensor assembly 300 includes a sensor support 320 which is rotatable via rotator shaft 323 and a rotator 325. The rotator 325 is depicted here as a manual rotator. It will be appreciated that the rotator 325 can be a motor for selectably rotating the sensor support 320. A second crystal mass-sensor 303 is shown schematically on the sensor support 320, and in a cleaning position which is shielded by a shield 329. Cleaning radiation is provided by a cleaning radiation unit 390R and is directed at the sensor 303 via a light guide 392 which can be an optical fiber bundle.

Turning to FIG. 8, a schematic top view of a portion of the ETL vapor deposition station 150 of FIG. 2 is shown. To preserve visual clarity of the drawing, the optical pyrometer 510, the bias heater power supply 520, the deposition rate monitor 420, the controller or amplifier 430, the vaporization heater power supply 440, and the cleaning radiation unit 390R have been omitted from the drawing of FIG. 8.

The "parked" position "P", the intermediate position "I" during motion of the source, and the end position "II" of forward motion "F" of the source, also being the beginning position of reverse motion "R" of the source, are shown. Also depicted are the connecting clamps 21c, 23c associated with the bias heater 20 (see FIGS. 5 and 6), and the connecting clamps 41c, 43c attached with the vaporization heater 40. Electrical leads 21w and 23w (coiled outline) and electrical leads 41w and 43w (wavy outline) are shown terminating at respective power feed throughs 526, 529 and 446, 449 in the chamber 150C. The holder or mask frame 151 has been omitted from the drawing.

As depicted in FIGS. 7 and 8, relative motion between the thermal physical vapor deposition source and the structure 11 is provided by moving the source with respect to a fixedly disposed structure which is held in the holder or mask frame 151.

Relative motion between the thermal physical vapor deposition source and the structure 11 can also be provided by moving the structure with respect to a fixedly disposed source via a lead screw which engages a suitably adapted holder or mask frame 151 (not shown). In this latter configuration, the mass-sensor assembly 300 can be fixedly positioned with respect to the source so as to provide for continuous sensing of vapor flux in a portion of the deposition zone 15v by a crystal mass-sensor such as, for example, a crystal mass-sensor 301.

As described previously, the drawings of FIGS. 2, 5, 6, 7, and 8 show, for illustrative purposes only, organic electron-transporting material and formation of an organic electron-transporting layer on a structure in the station 150, which is dedicated to that purpose in the OLED apparatus 100 of FIG. 2. It will be understood that doped or undoped organic electron-transporting layers 15 can be prepared by using one or more sources constructed in accordance with the present invention. Similarly, doped or undoped organic light-emitting layers 14 can be formed, and doped or undoped organic hole-transporting layers 13 can be vapor deposited onto a structure in respectively dedicated stations of the OLED apparatus 100 of FIG. 2. Also, a doped or undoped organic hole-injecting layer (not shown in the drawings) can be formed as a first layer on a structure.

The use of dopants to provide a doped layer on a structure has been described, for example, in the above-referenced US-A-4,769,292 in which one or more dopants are incorporated in an organic light-emitting layer to provide a shift of color or hue of emitted light. Such selected shifting or change of color is particularly desirable when constructing a multi-color or full-color organic light-emitting device.

So-called color-neutral dopants can be effectively used in conjunction with an organic hole-transporting layer and/or in conjunction with an organic electron-transporting layer to provide an organic light-emitting device having enhanced operational stability or extended operational life time, or enhanced electroluminescent efficiency.

The invention has been described in detail with particular reference to certain preferred embodiments thereof, but it will be understood that variations and modifications can be effected within the spirit and scope of the invention.

For example, a modification of the present invention includes the use of the thermal physical vapor deposition source for vapor deposition of one or more organic dopants onto a structure wherein the dopant or dopants are received in the electrically insulative container 30 either in the form of powders, flakes, or particles, or in the form of agglomerated pellets.

Another modification of the present invention includes the use of the thermal physical vapor deposition source for vapor deposition of a uniformly mixed organic host layer onto a structure wherein the organic host materials are received in the electrically insulative container 30, either in the form of powders, flakes, or particles, or in the form of agglomerated pellets.

Other features of the invention are included below.

The thermal physical vapor deposition source wherein the solid organic material received in the container includes at least one solid pellet of such organic material.

The thermal physical vapor deposition source wherein the means for providing relative motion between the vapor deposition source and the structure includes a lead screw adapted either to move the source with respect to a fixedly disposed structure, or to move the structure with respect to a fixedly disposed source.

The thermal physical vapor deposition source wherein the bias heater temperature-measuring device includes a pyrometer for measuring the temperature of the bias heater in a parked position of the vapor deposition source, the pyrometer providing a control signal corresponding to the temperature of the bias heater, and the control signal controlling a bias heater power supply for controllably applying an electrical potential to the bias heater.

The thermal physical vapor deposition source wherein the bias heater measuring device includes a thermocouple attached to the bias heater for measuring the temperature of the bias heater in at least a parked position of the vapor deposition source, the thermocouple providing a control signal corresponding to the temperature of the bias heater, and the control signal controlling a bias heater power supply for controllably applying an electrical potential to the bias heater.

The thermal physical vapor deposition source wherein the solid organic material received in the container includes one or more organic dopant materials.

The thermal physical vapor deposition source wherein the solid organic material received in the container includes one or more organic dopant materials.

The thermal physical vapor deposition source wherein the solid organic material received in the container includes one or more organic host materials.

The thermal physical vapor deposition source wherein the solid organic material received in the container includes one or more organic host materials.

## Claims

1. A thermal physical vapor deposition source for vaporizing solid organic materials and applying a vaporized organic material as a layer onto a surface of a structure in a chamber at reduced pressure in forming an organic light-emitting device (OLED), comprising:
a) a bias heater defined by side walls and a bottom wall, the side walls having a height dimension H_{B};
b) an electrically insulative container disposed in the bias heater, the container receiving solid organic material which can be vaporized, the container defined by side walls and a bottom wall, and the container side walls having a height dimension H_{C} which is greater than the height dimension H_{B} of the bias heater side walls;
c) a vaporization heater disposed on upper side wall surfaces of the container, the vaporization heater defining a vapor efflux slit aperture extending into the container for permitting vaporized organic material to pass through the slit aperture and onto the surface of the structure;
d) means for applying an electrical potential to the bias heater to cause bias heat to be applied to the solid organic material in the container, the bias heat providing a bias temperature which is insufficient to cause the solid organic material to vaporize;
e) means for applying an electrical potential to the vaporization heater to cause vaporization heat to be applied to uppermost portions of the solid organic material in the container causing such uppermost portions to vaporize so that vaporized organic material is projected onto the structure through the efflux slit aperture to provide an organic layer on the structure; and
f) means for providing relative motion between the vapor deposition source and the structure to provide a substantially uniform organic layer on the structure.

2. A thermal physical vapor deposition source for vaporizing solid organic materials and applying a vaporized organic material as a layer onto a surface of a structure in a chamber at reduced pressure in forming an organic light-emitting device (OLED), comprising:
a) a bias heater defined by side walls and a bottom wall, the side walls having a height dimension H_{B};
b) an electrically insulative container disposed in the bias heater, the container receiving solid organic material which can be vaporized, the container defined by side walls and a bottom wall, and the container side walls having a height dimension H_{C} which is greater than the height dimension H_{B} of the bias heater side walls;
c) a vaporization heater disposed on upper side wall surfaces of the container, the vaporization heater defining a vapor efflux slit aperture extending into the container for permitting vaporized organic material to pass through the slit aperture and onto the surface of the structure;
d) means for controllably applying an electrical potential to the bias heater in response to a control signal provided by a bias heater temperature-measuring device to cause controlled bias heat to be applied to the solid organic material in the container, the controlled bias heat providing a bias temperature which is insufficient to cause the solid organic material to vaporize;
e) means for controllably applying an electrical potential to the vaporization heater in response to a control signal provided by a deposition rate-measuring device to cause controlled vaporization heat to be applied to uppermost portions of the solid organic material in the container causing such uppermost portions to controllably vaporize so that vaporized organic material is projected onto the structure through the efflux slit aperture to provide an organic layer on the structure; and
f) means for providing relative motion between the vapor deposition source and the structure to provide a substantially uniform organic layer on the structure.

3. The thermal physical vapor deposition source of claim 1 wherein the solid organic material received in the container includes doped or undoped hole-injecting material, doped or undoped organic hole-transporting material, doped or undoped organic light-emitting material, or doped or undoped organic electron-transporting material.

4. The thermal physical vapor deposition source of claim 1 wherein the electrically insulative container is constructed of quartz or of a ceramic material.

5. The thermal physical vapor deposition source of claim 3 wherein the solid organic material received in the container includes powder, flakes, or particulates, and the vaporization heater further includes a baffle member connected to the vaporization heater and spaced therefrom in a direction towards the container, the baffle member substantially preventing ejection of particles of powder, flakes, or particulates through the vapor efflux slit aperture and permitting vaporized organic material to pass through the slit aperture.

6. The thermal physical vapor deposition source of claim 3 wherein the solid organic material received in the container includes at least one solid pellet of such organic material.

7. The thermal physical vapor deposition source of claim 1 wherein the means for providing relative motion between the vapor deposition source and the structure includes a lead screw adapted either to move the source with respect to a fixedly disposed structure, or to move the structure with respect to a fixedly disposed source.

8. The thermal physical vapor deposition source of claim 2 wherein the solid organic material received in the container includes doped or undoped hole-injecting material, doped or undoped organic hole-transporting material, doped or undoped organic light-emitting material, or doped or undoped organic electron-transporting material.

9. The thermal physical vapor deposition source of claim 2 wherein the electrically insulative container is constructed of quartz or of a ceramic material.

10. The thermal physical vapor deposition source of claim 8 wherein the solid organic material received in the container includes powder, flakes, or particulates, and the vaporization heater further includes a baffle member connected to the vaporization heater and spaced therefrom in a direction towards the container, the baffle member substantially preventing ejection of particles of powder, flakes, or particulates through the vapor efflux slit aperture and permitting vaporized organic material to pass through the slit aperture.
